(19) Europäisches Patentamt
European Patent Office
Office européen des brevets

(11) **EP 2 771 715 B1**

(12) **EUROPÄISCHE PATENTSCHRIFT**

(45) Veröffentlichungstag und Bekanntmachung des Hinweises auf die Patenterteilung:
**19.07.2017   Patentblatt 2017/29**

(21) Anmeldenummer: **11776360.7**

(22) Anmeldetag: **24.10.2011**

(51) Int Cl.:
*G01T 1/02* (2006.01)          *G01T 1/29* (2006.01)
*G01T 7/00* (2006.01)

(86) Internationale Anmeldenummer:
**PCT/EP2011/005353**

(87) Internationale Veröffentlichungsnummer:
**WO 2013/060342 (02.05.2013 Gazette 2013/18)**

(54) **VERFAHREN ZUR STRAHLUNGSMESSUNG MITTELS EINES ELEKTRONISCHEN ENDGERÄTS MIT EINER DIGITALKAMERA**

METHOD FOR MEASURING RADIATION BY MEANS OF AN ELECTRONIC TERMINAL HAVING A DIGITAL CAMERA

PROCÉDÉ DE MESURE DE RAYONNEMENT À L'AIDE D'UN TERMINAL ÉLECTRONIQUE DOTÉ D'UNE CAMÉRA NUMÉRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**03.09.2014   Patentblatt 2014/36**

(73) Patentinhaber: **Helmholtz Zentrum München - Deutsches**
**Forschungszentrum für Gesundheit und Umwelt (GmbH)**
**85764 Neuherberg (DE)**

(72) Erfinder:
• **KLEIN, Rolf-Dieter**
**80809 München (DE)**
• **REICHL, Mathias**
**93309 Kelheim (DE)**
• **HOESCHEN, Christoph**
**85241 Hebertshausen (DE)**

(74) Vertreter: **v. Bezold & Partner Patentanwälte - PartG mbB**
**Akademiestraße 7**
**80799 München (DE)**

(56) Entgegenhaltungen:
EP-A1- 0 757 474          WO-A1-2008/110182
DE-A1-102009 008 025     US-A- 4 381 450
US-A1- 2009 012 745      US-B1- 7 391 028

• Eric P Rubenstein ET AL: "Detection of Radioactivity in Transit Stations - Phase 2", , 1. Oktober 2009 (2009-10-01), Seiten 1-19, XP055031669, Gefunden im Internet: URL:http://onlinepubs.trb.org/onlinepubs/idea/finalreports/transit/transit54_final_report.pdf [gefunden am 2012-07-03]
• Anonym: "BQScan zur Messung radioaktiver Strahlung mit Digitalkameras", BQScan , Mai 2011 (2011-05), XP002679215, Gefunden im Internet: URL:http://bqscan.de/ [gefunden am 2012-07-04] & "Radioaktivität fotografierend feststellen", photoscala, 6. Mai 2011 (2011-05-06), Seiten 1-3, XP055031700, Gefunden im Internet: URL:http://www.photoscala.de/node/11394/pd f [gefunden am 2012-07-04]

EP 2 771 715 B1

**Beschreibung**

Die Erfindung betrifft ein Betriebsverfahren für ein elektronisches Endgerät mit einer integrierten Digitalkamera mit einem Bildsensor mit einer Vielzahl von Bildelementen, insbesondere für ein Mobiltelefon.

Aus dem Stand der Technik sind zur Messung der Strahlendosis von radioaktiver Strahlung Dosimeter bekannt, die beispielsweise als Stabdosimeter, Ionisationskammer, Filmdosimeter, Thermolumineszenzdosimeter oder als digitale elektronische Dosimeter ausgeführt sein können. Der Einsatz der bekannten elektronischen Dosimeter ist jedoch insbesondere dann problematisch, wenn eine hohe Dosisleistung (z.B. mehr als 100 G/h) gemessen werden soll, wie beispielsweise bei gepulster Strahlung bei einem Computertomographen (CT).

Ein Betriebsverfahren für ein elektronisches Endgerät gemäß dem Oberbegriff von Anspruch 1 ist beispielsweise bekannt aus Eric P. Rubenstein et al.: "Detection of Radioactivity in Transit Stations - Phase 2" (http://onlinepubs.trb.org/onlinepubs/idea/finalreports/trans it/transit54_final_report.pdf). Ferner ist zum Stand der Technik hinzuweisen auf US 7,391,028 B1, DE 10 2009 008 025 A1, US 2009/012745 A1, EP 0 757 474 A1, "BQScan zur Messung radioaktiver Strahlung mit Digitalkameras" (http://bqscan.de/), WO 2008/110182 A1 und US 4,381,450 A.

Der Erfindung liegt die Aufgabe zugrunde, eine alternative Möglichkeit zur Strahlungsmessung zu schaffen, die besonders gut zur Messung gepulster Strahlung geeignet ist. Diese Aufgabe wird durch ein erfindungsgemäßes Betriebsverfahren für ein elektronisches Endgerät sowie durch ein entsprechend arbeitendes Endgerät gemäß der Ansprüche 1 und 14 gelöst.

Die Erfindung beruht auf der technisch-physikalischen Erkenntnis, dass die in vielen elektronischen Endgeräten (z.B. Mobiltelefone, Notebooks, Netbooks, Laptops, etc.) heute eingebauten Digitalkameras nicht nur für elektromagnetische Strahlung im sichtbaren Wellenlängenbereich empfindlich sind, sondern auch für ionisierende Strahlung (z.B. radioaktive Strahlung), so dass diese Endgeräte auch zur Strahlungsmessung eingesetzt werden können.

Die einzelnen Bildelemente (Pixel) des Bildsensors der Digitalkamera liefern hierbei jeweils ein elektrisches Ausgangssignal entsprechend der einfallenden Strahlung. Im Rahmen des erfindungsgemäßen Betriebsverfahrens werden die Ausgangssignale der einzelnen Bildelemente jeweils mit einem unteren Grenzwert und einem oberen Grenzwert verglichen, wobei ein Zählereignis ausgelöst wird, wenn das Ausgangssignal zwischen dem unteren Grenzwert und dem oberen Grenzwert liegt. Die beiden Grenzwerte werden hierbei so festgelegt, dass sich die Digitalkamera zur Messung der jeweiligen Strahlung (z.B. radioaktive Strahlung) eignet.

Darüber hinaus sieht das erfindungsgemäße Betriebsverfahren vorzugsweise eine statistische Auswertung der Ausgangssignale der einzelnen Bildelemente des Bildsensors der Digitalkamera vor, um unter Verlust der ursprünglich vorhandenen Ortsauflösung des Bildsensors einen möglichst genauen Dosiswert der einfallenden ionisierenden Strahlung zu messen.

In einem bevorzugten Ausführungsbeispiel der Erfindung misst der Bildsensor mit seiner Vielzahl von Bildelementen eine Bildmatrix, wobei jedes Bildelement des Bildsensors einem Bildelement der Bildmatrix zugeordnet ist. Die Bildmatrix gibt also das von dem Bildsensor gemessene Bild in digitaler Form wieder. Die Erfindung sieht dann vor, dass die Bildmatrix statistisch ausgewertet wird und im Rahmen der statistischen Auswertung ein Dosiswert der auf den Bildsensor auftreffenden ionisierenden Strahlung ermittelt wird.

Darüber hinaus wird aus der Bildmatrix vorzugsweise eine Zählmatrix abgeleitet, wobei die Zählmatrix für die einzelnen Bildelemente der Bildmatrix jeweils einen zugehörigen Zähler enthält. Die einzelnen Zähler werden dann jeweils inkrementiert, wenn das zugehörige Bildelement der Bildmatrix zwischen einem unteren Grenzwert und einem oberen Grenzwert liegt. Im Rahmen der Erfindung kann die Zählmatrix unmittelbar aus der Bildmatrix berechnet werden. In dem bevorzugten Ausführungsbeispiel der Erfindung erfolgt jedoch zunächst eine Weiterverarbeitung der Bildmatrix, bevor die Zählmatrix berechnet wird.

Darüber hinaus sieht die Erfindung vor, dass die einzelnen Zähler der Zählmatrix zu einer Summe aufaddiert werden, wobei die Summe eine Energiedosis der ionisierenden Strahlung wiedergibt. Darüber hinaus kann im Rahmen der statistischen Auswertung auch eine Dosisleistung berechnet werden als Quotient aus der Energiedosis und der jeweiligen Messdauer.

Beim Betrieb einer Digitalkamera mit einem Bildsensor mit einer Vielzahl von Bildsensoren können einzelne Bildelemente fehlerbedingt ausfallen oder sich in ihrem Ansprechverhalten ändern, was zu einer entsprechenden Verfälschung der Strahlungsmessung führen würde. In dem bevorzugten Ausführungsbeispiel der Erfindung ist deshalb vorgesehen, dass eine Fehlermatrix ermittelt wird, die für jedes Bildelement der Bildmatrix ein Korrekturelement enthält. Die gemessene Bildmatrix wird dann mit der Fehlermatrix verknüpft, um Fehler der einzelnen Bildelemente kompensieren zu können. Beispielsweise können durch die Verknüpfung der Bildmatrix mit der Fehlermatrix einzelne defekte Bildelemente des Bildsensors ausgeblendet werden. Die Fehlermatrix kann jedoch auch für jedes Bildelement eine Korrekturkennlinie enthalten, um beispielsweise eine alterungsbedingte Kennlinienveränderung auszugleichen. Die Fehlermatrix kann beispielsweise im Rahmen des Kalibrierungsvorgangs ermittelt werden, wenn der Bildsensor einer vorgegebenen Strahlung ausgesetzt wird.

Weiterhin ist im Rahmen der Erfindung vorzugsweise vorgesehen, dass die von dem Bildsensor jeweils aktuell gemessene Bildmatrix zwischengespeichert wird, wobei die aktuell gemessene Bildmatrix mit einer zuvor gemessenen und zwischengespeicherten Bildmatrix verglichen wird, um zwischenzeitliche Änderungen zu erfassen. Auf diesem Wege wird also vorzugsweise eine Differenzmatrix berechnet als Differenz einer aktuell gemessenen Bildmatrix mit einer zuvor gemessenen zwischengespeicherten Bildmatrix. Die vorstehend erwähnte statistische Auswertung erfolgt dann vorzugsweise auf der Grundlage der Differenzmatrix.

Das vorstehend beschriebene erfindungsgemäße Verfahren ermöglicht zunächst nur eine Messung einer Strahlungsdosis oder eine Dosisleistung. Es besteht jedoch im Rahmen der Erfindung grundsätzlich auch die Möglichkeit, die Spektralverteilung der einfallenden ionisierenden Strahlung zumindest näherungsweise zu erfassen. Hierbei wird die Tatsache ausgenutzt, dass einfallende Photonen auf dem Bildsensor in Abhängigkeit von der Photonenenergie zu einem Übersprechen zwischen benachbarten Bildelementen führen. So führt ein relativ schwaches Photon in der Regel nur zu einem Zählereignis in einem einzigen Bildelement des Bildsensors. Hochenergetische Photonen führen dagegen zu Zählereignissen in einer ganzen Gruppe von benachbarten Bildelementen des Bildsensors, wobei die räumliche Ausdehnung der Gruppe von Zählereignissen die Photonenenergie wiedergibt. Die Erfindung sieht deshalb vorzugsweise vor, dass in der Zählmatrix Gruppen (Cluster) von benachbarten Zählereignissen ermittelt werden. Darüber hinaus wird dann die räumliche Ausdehnung der einzelnen Gruppen von benachbarten Zählereignissen ermittelt, um daraus die zugehörige Photonenenergie abzuleiten. Durch eine entsprechende Bildauswertung lässt sich also im Rahmen des erfindungsgemäßen Verfahrens auch eine Spektralverteilung der einfallenden Strahlung ermitteln.

Die erfindungsgemäße Strahlungsmessung mittels eines elektronischen Endgeräts (z.B. Mobiltelefon) bietet auch die Möglichkeit, dass der gemessene Dosiswert oder ein daraus abgeleitetes Steuersignal mittels eines in dem Endgerät befindlichen Senders von dem Endgerät zu einer externen Überwachungseinrichtung übertragen wird. Bei der Strahlungsmessung mit einem Mobiltelefon kann diese Kommunikation beispielsweise über eine entsprechende Mobiltelefonverbindung erfolgen. Es besteht jedoch im Rahmen der Erfindung auch die Möglichkeit, dass diese Kommunikation mittels eines Bluetooth-Moduls, mittels eines RFID-Transponders (RFID: Radio-Frequency Identification) oder mittels eines WLAN-Moduls (WLAN: Wireless Local Area Network) erfolgt.

In diesem Zusammenhang ist auch zu erwähnen, dass nicht nur die Möglichkeit besteht, den gemessenen Dosiswert von dem Endgerät zu der externen Überwachungseinrichtung zu übertragen. Beispielsweise kann auch ein Steuersignal (z.B. ein Not-Aus-Signal) von dem Endgerät zu einer externen Überwachungseinrichtung übertragen werden, wobei das Steuersignal in der Regel aus dem gemessenen Dosiswert abgeleitet ist. Beispielsweise kann die Überwachungseinrichtung mit einer Strahlungsquelle (z.B. Computertomograph) verbunden sein und die Strahlungsquelle abschalten, wenn die von den Endgeräten (z.B. Mobiltelefone) eingehenden Dosiswerte einen Grenzwert überschreiten.

Darüber hinaus bieten moderne elektronische Endgeräte (z.B. Mobiltelefone) oftmals die Möglichkeit der Bestimmung der geografischen Position mittels eines eingebauten Satellitennavigationsempfängers, wie beispielsweise eines GPS-Moduls (GPS: Global Positioning System). In dem bevorzugten Ausführungsbeispiel der Erfindung ist deshalb auch vorgesehen, dass zusammen mit dem gemessenen Dosiswert auch die geografische Position des jeweiligen Endgeräts zu der externen Überwachungseinrichtung übertragen wird. Die externe Überwachungseinrichtung kann auf diese Weise Dosiswerte und Positionen einer Vielzahl von räumlich verteilten Endgeräten auswerten und auf diese Weise eine geografische Karte der Dosiswerte herstellen.

Im Rahmen des erfindungsgemäßen Betriebsverfahrens ist vorzugsweise auch eine Kalibrierung vorgesehen, indem das Endgerät einem als Normal dienenden Strahler ausgesetzt wird.

Bei dem im Rahmen der Erfindung verwendeten Endgerät kann es sich beispielsweise um ein Mobiltelefon mit einer integrierten Digitalkamera handeln, wobei sogenannte Smart-Phones besonders geeignet sind, da die Strahlungsmessung im Rahmen eines Anwendungsprogramms ("App") auf dem Smart-Phone laufen kann. Die Erfindung ist jedoch hinsichtlich des verwendeten Endgeräts nicht auf Mobiltelefone beschränkt, sondern beispielsweise auch mit Digitalkameras oder mit transportablen Computern realisierbar, wie beispielsweise Notebooks, Laptops oder Netbooks. Im Rahmen der Erfindung ist lediglich erforderlich, dass das Endgerät eine integrierte Digitalkamera mit einem Bildsensor mit einer Vielzahl von Bildelementen aufweist.

Bei dem Bildsensor kann es sich beispielsweise um einen CCD-Sensor (CCD: Charge Coupled Device) oder um einen CMOS-Sensor (CMOS: Complementary Metal Oxide Semiconductor) handeln, jedoch ist die Erfindung grundsätzlich auch mit anderen Typen von Bildsensoren realisierbar.

Auch der im Rahmen der Erfindung verwendete Begriff eines Dosiswerts ist allgemein zu verstehen und umfasst beispielsweise die Energiedosis, die Äquivalentdosis oder auch die Dosisleistung der einfallenden ionisierenden Strahlung.

Weiterhin ist zu bemerken, dass sich die Erfindung besonders gut zur Messung gepulster Strahlung eignet. Hierbei ist zu beachten, dass die einzelnen Bildelemente des Bildsensors jeweils periodisch ausgelesen werden, wobei zwischen unmittelbar aufeinander folgenden Auslesevorgängen jeweils eine Totzeit liegt, innerhalb derer das jeweilige Bildelement insensitiv ist und keine Strahlung detektiert. Bei der Messung gepulster, periodischer Strahlung besteht deshalb die Gefahr, dass die einzelnen Strahlungspulse jeweils in die Totzeit fallen und deshalb nicht detektiert werden.

Die Erfindung sieht deshalb vor, dass die einzelnen Bildelemente des Bildsensors zeitversetzt ausgelesen werden, so dass auch die Totzeiten der einzelnen Bildelemente zeitversetzt sind. Dadurch wird verhindert, dass die Strahlungsimpulse bei allen Bildelementen des Bildsensors in die Totzeit fallen.

Weiterhin ist zu erwähnen, dass die Erfindung eine Messung der Dosisleistung in einem großen Messbereich von 1 μG/h-100g/h ermöglicht. Derzeit ermöglicht kein elektronisches Dosimeter ohne Hardware-Modifikationen (z.B. Abschwächungsplatten) einen derart großen Messbereich.

Darüber hinaus ist zu bemerken, dass die Erfindung nicht beschränkt ist auf Endgeräte, bei denen der Bildsensor Bestandteil einer integrierten Digitalkamera ist. Vielmehr beansprucht die Erfindung auch Schutz für entsprechende Endgeräte, bei denen der Bildsensor nicht Bestandteil einer Digitalkamera ist, sondern anderen Zwecken dient.

Auch der im Rahmen der Erfindung verwendete Begriff der ionisierenden Strahlung ist allgemein zu verstehen und umfasst beispielsweise radioaktive Strahlung, Alphastrahlung, Betastrahlung, Gammastrahlung, ultraviolette Strahlung, Myonenstrahlung, Protonenstrahlung, Neutronenstrahlung und Röntgenstrahlung.

Ferner ist zu erwähnen, dass die Erfindung nicht auf das vorstehend beschriebene Betriebsverfahren für ein elektronisches Endgerät beschränkt ist, sondern auch Schutz beansprucht für ein Endgerät, auf dem das erfindungsgemäße Betriebsverfahren ausgeführt wird.

Schließlich umfasst die Erfindung auch die neuartige Verwendung eines elektronischen Endgeräts (z.B. Mobiltelefon) mit einer integrierten Digitalkamera mit einem Bildsensor zur Ermittlung eines Dosiswerts einer auf den Bildsensor auftreffenden ionisierenden Strahlung.

Andere vorteilhafte Weiterbildungen der Erfindung sind in den Unteransprüchen gekennzeichnet oder werden nachstehend zusammen mit der Beschreibung der bevorzugten Ausführungsbeispiele der Erfindung anhand der Figuren näher erläutert. Es zeigen:

Figur 1                 eine schematische Darstellung eines erfindungsgemäßen Systems zur Messung von Strahlendosen mittels zahlreicher Mobiltelefone, die jeweils eine integrierte Digitalkamera aufweisen.

Figuren 2A und 2B       ein Flussdiagramm zur Verdeutlichung des erfindungsgemäßen Betriebsverfahrens,

Figur 3                 Messdiagramme unter Verwendung des erfindungsgemäßen Verfahrens,

Figur 4                 eine schematische Darstellung zur Verdeutlichung des erfindungsgemäßen Verfahrens.

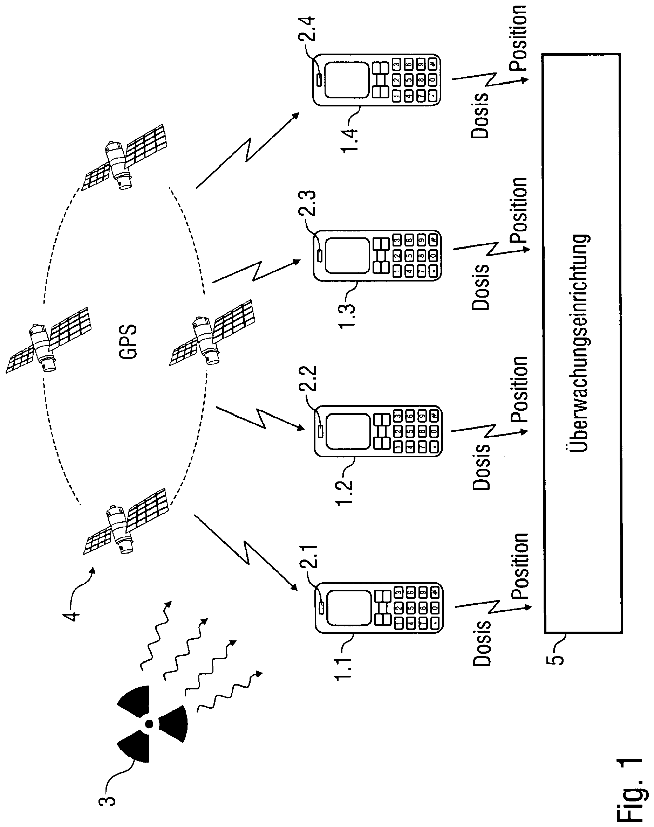

Figur 1 zeigt ein erfindungsgemäßes System zur Ermittlung der räumlichen Verteilung von radioaktiven Strahlendosen mittels mehrerer Mobiltelefone 1.1-1.4, die jeweils eine integrierte Digitalkamera 2.1-2.4 aufweisen, die im Rahmen der Erfindung zur Strahlungsmessung eingesetzt wird.

Die Zeichnung zeigt schematisch eine radioaktive Strahlungsquelle 3, die radioaktive Strahlung emittiert, wobei die radioaktive Strahlung auf die Digitalkameras 2.1-2.4 der Mobiltelefone 1.1-1.4 trifft und dort detektiert wird, wie noch detailliert beschrieben wird.

Die einzelnen Mobiltelefone 1.1-1.4 weisen jeweils einen GPS-Sensor (nicht dargestellt) auf, der mittels eines GPS-Satellitennavigationssystems 4 die aktuelle Position der einzelnen Mobiltelefone 1.1-1.4 ermittelt, was an sich aus dem Stand der Technik bekannt ist und deshalb nicht näher beschrieben werden muss.

Die einzelnen Mobiltelefone 1.1-1.4 ermitteln jeweils die Strahlungsdosis der einfallenden radioaktiven Strahlung am Ort des jeweiligen Mobiltelefons 1.1-1.4 und übertragen den gemessenen Dosiswert zusammen mit der satellitengestützt ermittelten Position des jeweiligen Mobiltelefons 1.1-1.4 an eine zentrale Überwachungseinrichtung 5. Die zentrale Überwachungseinrichtung 5 kann dann aus den gemessenen Dosiswerten und den zugehörigen Positionswerten eine geografische Verteilung der Strahlungsdosis berechnen.

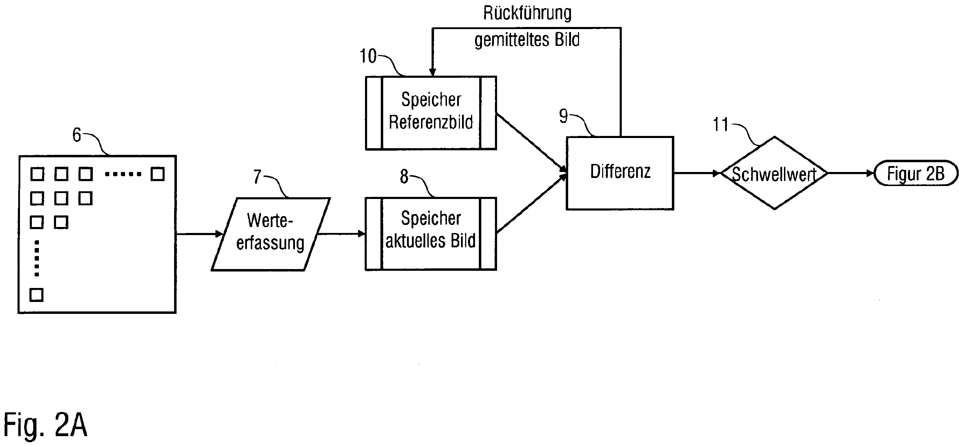

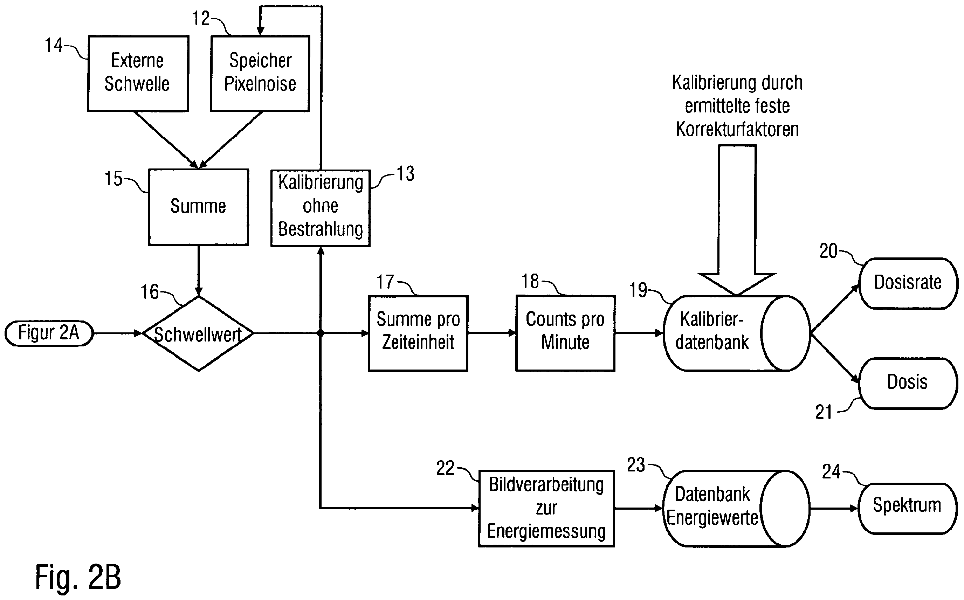

Die Figuren 2A und 2B zeigen das erfindungsgemäße Betriebsverfahren für die Mobiltelefone 1.1-1.4 in Form eines Flussdiagramms.

Zunächst zeigen die Zeichnungen einen Bildsensor 6 mit zahlreichen matrixförmig angeordneten Bildelementen zur Strahlungsmessung. Bei dem Bildsensor 6 kann es sich beispielsweise um einen CCD-Sensor oder um einen CMOS-Sensor handeln.

In einem Schritt 7 erfolgt eine Werteerfassung der von dem Bildsensor 6 gemessenen Bilder mit einer Frame-Rate von 40-60 fps (frames per second). Optional sind auch Einzelbilder möglich, die dann ggf. mit Shutter-Zeiten, die Teilbilderaufnahmen entsprechen oder umgekehrt Langzeitbelichtungen mit ganz großen Shutter-Zeiten.

Die gemessenen Bilder werden dann in einem Schritt 8 in einem Bildspeicher gespeichert.

Anschließend erfolgt in einem Schritt 9 eine Differenzbildung zwischen dem in dem Schritt 8 gespeicherten aktuellen Bild und einem in einem Schritt 10 gespeicherten Referenzbild, wobei ein Referenzspeicher eine Durchschnittshelligkeit pro Bildelement (Pixel) von den vorherigen Bildaufnahmen enthält. Die somit erreichte Mittelung kann in Abhängigkeit von der aktuellen Differenz erfolgen, beispielsweise nach folgender Formel:

$$\text{Ref} = \text{Ref·n} + \text{neues Pixel} \cdot m/(n+m)$$

mit

Ref:          Helligkeit des Referenzbilds

n:          Gewichtungsfaktor für die Berücksichtigung des Referenzbildes mit n+m=1

m:          Gewichtungsfaktor für die Berücksichtigung des neuen Bildes mit n+m=1

neues Pixel:    Helligkeit des neuen Bildes

Die so ermittelte Differenz wird dann in einem Schritt 11 mit einem oberen Grenzwert und einem unteren Grenzwert verglichen, wobei ein Zählereignis ausgelöst wird, wenn der gemessene Differenzwert zwischen dem oberen Grenzwert und dem unteren Grenzwert liegt.

Optional besteht die in Figur 2B dargestellte Möglichkeit eines Speichers 12 für Pixelrauschen, der bei einem Kalibriervorgang 13 mit den Rauschwerten pro Pixel gefüllt wird. Dazu werden mehrere Messungen bei Dunkelheit und ohne Bestrahlung durchgeführt. Die einzelnen Differenzen zwischen aktuellem Bild und letztem Bild werden mit einer Matrix aufsummiert (Rauschwerte pro Pixel) und dann z.B. maximale Werte bzw. nach statistischer Auswertung die ermittelten Werte gespeichert (Gauß-Verteilung unter Berücksichtigung von einfallender Background-Strahlung). Darüber hinaus kann eine externe Schwelle 14 hinzugefügt werden, die auf die Pixelschwelle aus dem Speicher 12 in einem Schritt 15 aufaddiert werden kann, was für stabilere Ergebnisse sorgt.

Ein Schwellenwertvergleich 16 liefert dann ein analoges oder digitales Signal, wenn Schwellenwerte überschritten bzw. - bei negativem Vorzeichen - unterschritten werden. In einem Schritt 17 werden die Zählereignisse dann über eine bestimmte Zeiteinheit aufsummiert.

Daraufhin wird in einem Schritt 18 die Anzahl der Zählereignisse (Counts) pro Minute berechnet.

Über eine Kalibriertabelle 19 wird dann die Zuordnung zu einer genormten Dosisleistung (z.B. aus Counts pro Minute) bzw. Dosis (aus Gesamtzahl der Counts) erstellt. Die Kalibrierungstabelle kann für eine Gruppe von Sensoren oder individuell erstellt werden durch einen Messvorgang mit kalibrierter Strahlungsquelle. Optional kann ein Korrekturfaktor zur vereinfachten Kalibrierung mit ein oder zwei Punkten vorgesehen sein.

Im Ergebnis wird dann in einem Schritt 20 eine Dosisrate und in einem Schritt 21 eine Dosis ausgegeben.

Darüber hinaus besteht auch die Möglichkeit für eine Bildverarbeitung 22 zur Ermittlung der Energiewerte der einfallenden Photonen. So lösen niedrigenergetische Photonen in der Regel nur ein Zählereignis in einem einzigen Bildelement des Bildsensors 6 aus. Hochenergetische Photonen führen dagegen zu einem Übersprechen zwischen benachbarten Bildelementen des Bildsensors 6, so dass eine Gruppe (Cluster) von mehreren benachbarten Bildelementen des Bildsensors 6 ein Zählereignis auslöst. Durch die Bildverarbeitung 22 können dann derartige Gruppen von aktivierten Bildelementen ermittelt werden, wodurch sich näherungsweise eine Spektralverteilung berechnen lässt. Die so gewonnenen Werte werden mit einer Datenbank 23 der Energiewerte verglichen, woraufhin dann in einem Schritt 24 ein Spektrum der einfallenden Strahlung ausgegeben wird.

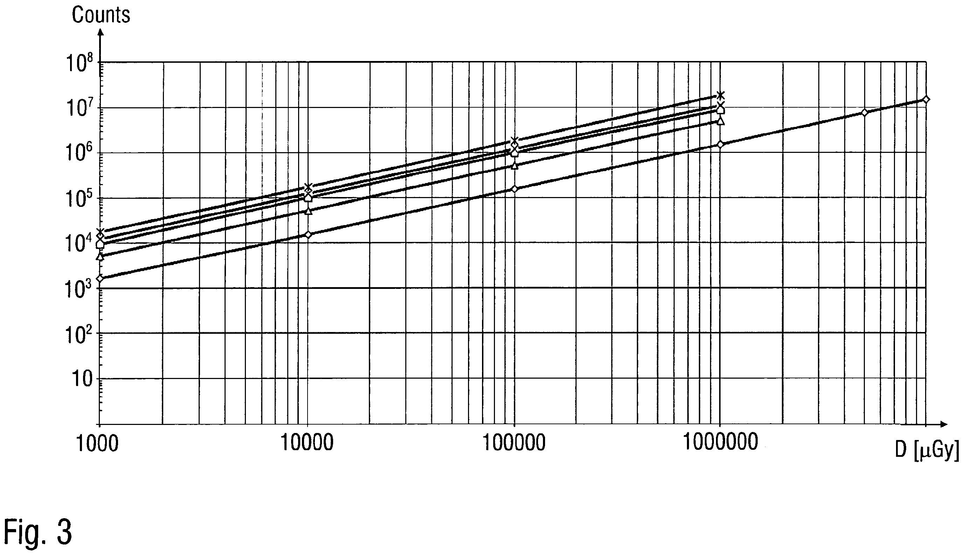

Figur 3 zeigt für verschieden Handy-Typen die gemessen Zählereignisse (Counts) als Funktion der Energiedosis D der einfallenden radioaktiven Strahlung. Aus dem Diagramm ist ersichtlich, dass die Kennlinien im doppelt logarithmischen Maßstab äußerst linear verlaufen, was eine entsprechende Eignung für messtechnische Zwecke zeigt.

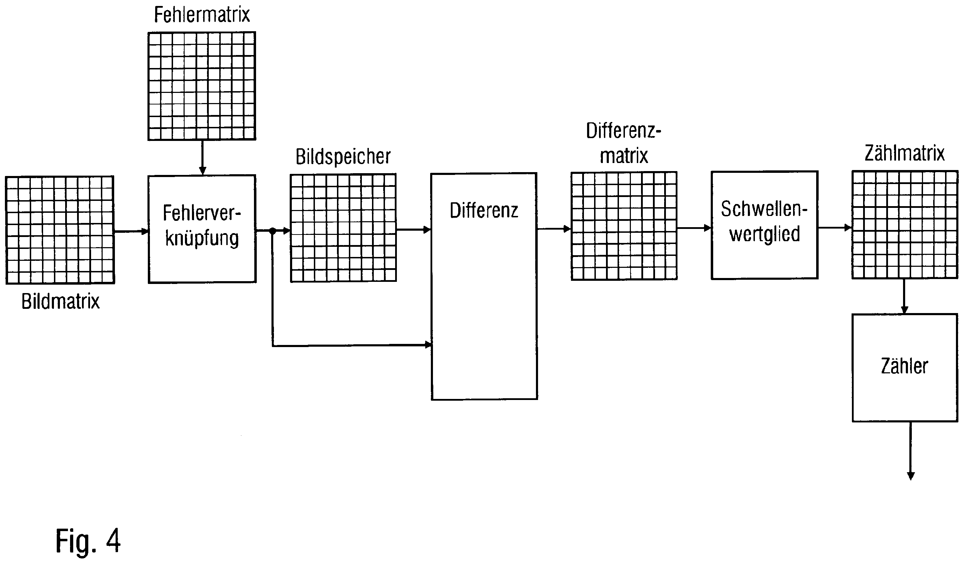

Figur 4 zeigt das erfindungsgemäße Prinzip nochmals schematisch in vereinfachter Form.

So misst ein Bildsensor zunächst eine Bildmatrix, die dann mit einer Fehlermatrix verknüpft wird, um fehlerbedingt ausgefallene Bildelemente der Bildmatrix für die nachstehende Signalauswertung auszublenden. Darüber hinaus ermöglicht die Fehlermatrix eine Anpassung der jeweiligen Kennlinien der einzelnen Bildelemente, um beispielsweise alterungsbedingte Defekte auszugleichen. Die so gewonnene Bildmatrix wird dann in einem Bildspeicher zwischengespeichert.

Anschließend erfolgt eine Differenzbildung zwischen dem aktuell gewonnenen Bild und dem in dem Bildspeicher zwischengespeicherten früheren Bild, wobei das Ergebnis in einer Differenzmatrix abgespeichert wird.

Ein Schwellenwertglied überprüft dann anschließend, ob die einzelnen Werte der Differenzmatrix zwischen einem oberen Grenzwert und einem unteren Grenzwert liegen. Falls dies der Fall ist, so wird in einer Zählmatrix ein Zählereignis ausgelöst.

Schließlich misst dann ein Zähler die Anzahl der Zählereignisse innerhalb der gesamten Zählmatrix, wobei die Ortsauflösung verloren geht und die Berücksichtigung sämtlicher Elemente der Zählmatrix zu einer hochgenauen Bestimmung der Dosis führt.

Bezugszeichenliste:

| | |
|---|---|
| 1.1-1.4 | Mobiltelefone |
| 2.1-2.4 | Digitalkameras |
| 3 | Strahlungsquelle |
| 4 | GPS-Satellitennavigationssystem |
| 5 | Überwachungseinrichtung |
| 6 | Bildsensor |
| 7 | Schritt "Werteerfassung" |
| 8 | Schritt "Speichern" |
| 9 | Schritt "Differenzbildung" |
| 10 | Schritt "Referenzbild" |
| 11 | Schritt "Schwellenwertprüfung" |
| 12 | Speicher für Pixelrauschen |
| 13 | Kalibriervorgang |
| 14 | Externe Schwelle |
| 15 | Schritt "Summenbildung" |
| 16 | Schwellenwertvergleich |
| 17 | Schritt "Aufsummierung pro Zeiteinheit" |
| 18 | Schritt "Counts pro Minute" |
| 19 | Kalibriertabelle |
| 20 | Ausgabe Dosisrate |
| 21 | Ausgabe Dosis |
| 22 | Bildverarbeitung |
| 23 | Datenbank der Energiewerte |
| 24 | Ausgabe Spektrum |

**Patentansprüche**

**1.** Betriebsverfahren für ein elektronisches Endgerät (1.1-1.4) mit einem Bildsensor (6) mit einer Vielzahl von Bildelementen, insbesondere für ein Mobiltelefon, das Betriebsverfahren umfassend den Schritt Ermitteln mittels des Bildsensors (6) eines Dosiswerts einer auf den Bildsensor (6) auftreffenden ionisierenden Strahlung, wobei a) die einzelnen Bildelemente des Bildsensors (6) jeweils periodisch ausgelesen werden,

b) dass zwischen unmittelbar aufeinander folgenden Auslesevorgängen jeweils eine Totzeit liegt, innerhalb derer das jeweilige Bildelement insensitiv ist und keine Strahlung detektiert,
c) dass die Bildelemente des Bildsensors (6) zeitversetzt ausgelesen werden, so dass auch die Totzeiten der einzelnen Bildelemente zeitversetzt sind.

**2.** Betriebsverfahren nach Anspruch 1, **gekennzeichnet durch** folgende Schritte:

a) Messen einer Bildmatrix durch den Bildsensor (6), wobei die Bildmatrix für die einzelnen Bildelemente des Bildsensors (6) jeweils ein zugehöriges Bildelement enthält und den einzelnen Bildelementen der Bildmatrix jeweils ein elektrisches Ausgangssignal des zugehörigen Bildelements des Bildsensors (6) zugeordnet wird,
b) Statistische Auswertung der Bildmatrix und Berechnen des Dosiswerts im Rahmen dieser statistischen Auswertung.

**3.** Betriebsverfahren nach Anspruch 2, **gekennzeichnet durch** folgende Schritte:

a) Berechnen einer Zählmatrix aus der Bildmatrix, wobei die Zählmatrix für die einzelnen Bildelemente der Bildmatrix jeweils einen zugehörigen Zähler enthält,
b) Inkrementieren der einzelnen Zähler der Zählmatrix, wenn das zugehörige Bildelement der Bildmatrix zwischen einem unteren Grenzwert und einem oberen Grenzwert liegt.

**4.** Betriebsverfahren nach Anspruch 3, **gekennzeichnet durch** folgenden Schritt im Rahmen der statistischen Auswertung:

a) Addieren der Zähler der Zählmatrix zu einer Summe, die eine Energiedosis der ionisierenden Strahlung wiedergibt, und/oder
b) Berechnen einer Dosisleistung als Quotient aus der Energiedosis und einer Messdauer.

5. Betriebsverfahren nach einem der vorhergehenden Ansprüche, **gekennzeichnet durch** folgenden Schritt:

a) Ermitteln einer Fehlermatrix mit einer Vielzahl von Korrekturelementen, wobei die einzelnen Korrekturelemente der Fehlermatrix jeweils einem Bildelement der Bildmatrix zugeordnet sind,
b) Verknüpfen der Bildmatrix mit der Fehlermatrix zur Kompensation von Fehlern der einzelnen Bildelemente des Bildsensors (6).

6. Betriebsverfahren nach einem der vorhergehenden Ansprüche, **gekennzeichnet durch** folgenden Schritt:

a) Zwischenspeichern der von dem Bildsensor (6) gemessenen Bildmatrix,
b) Berechnen einer Differenzmatrix als Differenz einer aktuell gemessenen Bildmatrix mit einer zuvor gemessenen und zwischengespeicherten Bildmatrix,
c) Durchführung der statistischen Auswertung auf der Grundlage der Differenzmatrix.

7. Betriebsverfahren nach einem der vorhergehenden Ansprüche, **gekennzeichnet durch** folgenden Schritt:

Ermittlung einer Spektralverteilung der ionisierenden Strahlung durch eine Auswertung der Zählmatrix.

8. Betriebsverfahren nach Anspruch 7,
**gekennzeichnet durch** folgende Schritte:

a) Ermittlung von Gruppen von benachbarten Zählereignissen in der Zählmatrix,
b) Ermittlung der räumlichen Ausdehnung der Gruppen,
c) Ermittlung der Energie der verursachenden Strahlung aus der räumlichen Ausdehnung der Gruppen.

9. Betriebsverfahren nach einem der vorhergehenden Ansprüche, **gekennzeichnet durch** folgenden Schritt:

Übertragen des gemessenen Dosiswerts und/oder eines daraus abgeleiteten Steuersignals mittels eines in dem Endgerät (1.1-1.4) befindlichen Senders von dem Endgerät (1.1-1.4) zu einer externen Überwachungseinrichtung (5), insbesondere mittels eines Bluetooth-Moduls, eines RFID-Transponders, eines Mobiltelefons oder eines WLAN-Moduls.

10. Betriebsverfahren nach Anspruch 9, **gekennzeichnet durch** folgenden Schritt:

a) Erfassen einer geografischen Position des Endgeräts (1.1-1.4) mittels eines in das Endgerät (1.1-1.4) integrierten Positionssensors, insbesondere mittels eines Satellitennavigationsempfängers,
b) Übertragen der geografischen Position von dem Endgerät (1.1-1.4) zu der externen Überwachungseinrichtung (5).

11. Betriebsverfahren nach einem der vorhergehenden Ansprüche, **gekennzeichnet durch** folgenden Schritt:

Kalibrieren der Berechnung des Dosiswerts, indem das Endgerät (1.1-1.4) einem Strahler als Normal ausgesetzt wird.

12. Betriebsverfahren nach einem der vorhergehenden Ansprüche, **dadurch gekennzeichnet, dass** das Endgerät (1.1-1.4)

a) ein Mobiltelefon, insbesondere ein Smart-Phone,
b) eine Digitalkamera, oder
c) ein transportabler Computer, insbesondere ein Notebook, ein Laptop, ein Netbook,

ist.

**13.** Betriebsverfahren nach einem der vorhergehenden Ansprüche, **dadurch gekennzeichnet, dass** der Bildsensor (6) ein CCD-Sensor oder ein CMOS-Sensor ist.

**14.** Endgerät (1.1-1.4), insbesondere Mobiltelefon, mit

   a) einem Bildsensor (6) mit einer Vielzahl von Bildelementen,
   b) einem Programmspeicher zur Speicherung eines Anwendungsprogramms und
   c) einem Prozessor zum Ausführen des Anwendungsprogramms, **dadurch gekennzeichnet,**
   d) **dass** das in dem Programmspeicher gespeicherte Anwendungsprogramm bei Ausführung durch den Prozessor, den Prozessor veranlasst, das Betriebsverfahren nach einem der vorhergehenden Ansprüche auszuführen.

**15.** System zur Strahlungsmessung mit

   a) mehreren Endgeräten (1.1-1.4) gemäß Anspruch 14 und
   b) einer Überwachungseinrichtung (5) sowie mit
   c) einer drahtlosen Verbindung zwischen den Endgeräten und der Überwachungseinrichtung (5), wobei die Endgeräte (1.1-1.4) den gemessenen Dosiswert und/oder die geografische Position des jeweiligen Endgeräts (1.1-1.4) über die drahtlose Verbindung zu der Überwachungseinrichtung übertragen.

**Claims**

**1.** Operating method for an electronic terminal unit (1.1-1.4) with an image sensor (6) with a plurality of image elements, in particular for a mobile phone, the operating method comprising the step of determining a dosage value of an ionizing radiation impinging on the image sensor (6) by means of the image sensor (6), wherein

   a) the individual image elements of the image sensor (6) are each read-out periodically,

**characterized**

   b) in that a dead time lies between directly sequential read operations, respectively, within which the respective image element is insensitive and detects no radiation,
   c) in that the image elements of the image sensor (6) are read-out in a time-shifted manner, so that the dead times of the individual image elements are also time-shifted.

**2.** Operating method according to Claim 1, **characterized by** the following step:

   a) measuring an image matrix through the image sensor (6), wherein the image matrix for the individual image elements of the image sensor (6) respectively contains an associated image element and the individual image elements of the image matrix are respectively assigned to an electric output signal associated with the image element of the image sensor (6),
   b) statistical evaluation of the image matrix and calculation of the dosage value in the framework of this statistical evaluation.

**3.** Operating method according to Claim 2, **characterized by** the following step:

   a) Calculating a counting matrix from the image matrix, wherein the counting matrix for the individual image elements of the image matrix respectively contains an associated counter,
   b) incrementing the individual counters of the counting matrix when the associated image element of the image matrix lies between a lower limit value and an upper limit value.

**4.** Operating method according to Claim 3, **characterized by** the following step in the framework of statistical evaluation:

   a) adding the counters of the counting matrix to have a sum, which reproduces an energy dose of the ionizing radiation, and/or
   b) computing a dose rate as the quotient of the energy dose and a duration of measurement.

**5.** Operating method according to any one of the preceding claims, **characterized by** the following step:

a) determining an error matrix with a plurality of correction elements, wherein the individual correction elements of the error matrix are respectively assigned to an image element of the image matrix,
b) linking the image matrix with the error matrix for compensation of errors of the individual image elements of the image sensor (6).

**6.** Operating method according to any one of the preceding claims, **characterized by** the following step:

a) intermediate storage of the image matrix measured by the image sensor (6),
b) calculating a difference matrix as the difference of a currently measured image matrix with a previously measured and temporarily stored image matrix,
c) carrying out the statistical evaluation based on the difference matrix.

**7.** Operating method according to any one of the preceding claims, **characterized by** the following step:

Determining a spectral distribution of the ionizing radiation through evaluation of the counting matrix.

**8.** Operating method according to claim 7, **characterized by** the following steps:

a) determining groups of neighboring counting events in the counting matrix,
b) determining the spatial extension of the groups,
c) determining the energy of the causing radiation from the spatial extension of the groups.

**9.** Operating method according to any one of the preceding claims, **characterized by** the following step:

Transmission of the measured dosage value and/or a control signal derived therefrom by means of a transmitter located in the terminal unit (1.1-1.4) from the terminal unit (1.1-1.4) to an external monitoring device (5), particularly by means of a Bluetooth module, an RFID transponder, a mobile phone or a WLAN module.

**10.** Operating method according to claim 9, **characterized by** the following step:

a) detecting a geographical position of the terminal unit (1.1-1.4) by means of a position sensor integrated in the terminal unit (1.1-1.4), in particular by means of a satellite navigation receiver,
b) transmission of the geographical position from the terminal unit (1.1-1.4) to the external monitoring device (5).

**11.** Operating method according to any one of the preceding claims, **characterized by** the following step:

calibration of the calculation of the dosage value in such a way that the terminal unit (1.1-1.4) is exposed to a radiator as normal.

**12.** Operating method according to any one of the preceding claims, **characterized in that** the terminal unit (1.1-1.4) is

a) a mobile phone, in particular a smartphone,
b) a digital camera, or
c) a transportable computer, in particular a notebook, a laptop, a netbook.

**13.** Operating method according to any one of the preceding claims, **characterized in that** the image sensor (6) is a CCD sensor or a CMOS sensor.

**14.** A terminal unit (1.1-1.4), in particular a mobile phone, with

a) an image sensor (6) with a plurality of image elements,
b) a program memory for storing an application program and
c) a processor for executing the application program,

**characterized**

d) in that the application program saved in the program memory on execution causes the processor to execute the operating method according to any one of the preceding claims.

**15.** A system for radiation measurement with

a) several terminal units (1.1-1.4) according to claim 14 and
b) a monitoring device (5) as well as with
c) a wireless connection between the terminal units and the monitoring device (5), wherein the terminal units (1.1-1.4) transmit the measured dosage value and/or the geographical position of the respective terminal units (1.1-1.4) via the wireless connection to the monitoring device.

**Revendications**

**1.** Procédé de fonctionnement pour un terminal (1.1 - 1.4) électronique avec un capteur d'images (6) avec une pluralité d'éléments d'image, en particulier pour un téléphone mobile, lequel procédé de fonctionnement comprend l'étape consistant à déterminer, au moyen du capteur d'images (6), une valeur de dose d'un rayonnement ionisant arrivant sur le capteur d'images (6), dans lequel a) les divers éléments d'image du capteur d'images (6) sont lus respectivement périodiquement,
**caractérisé en ce**

b) que se trouve, entre des opérations de lecture se suivant directement les unes les autres, respectivement un temps mort, à l'intérieur duquel l'élément d'image respectif est insensible et ne détecte aucun rayonnement,
c) que les éléments d'image du capteur d'images (6) sont lus avec un décalage dans le temps de sorte que les temps morts des divers éléments d'image soient également décalés dans le temps.

**2.** Procédé de fonctionnement selon la revendication 1, **caractérisé par** les étapes qui suivent consistant à :

a) mesurer une matrice d'image par le capteur d'images (6), dans lequel la matrice d'image contient, pour les divers éléments d'image du capteur d'images (6), respectivement un élément d'image associé et respectivement un signal de sortie électrique de l'élément d'image associé du capteur d'images (6) est associé aux divers éléments d'image de la matrice d'image,
b) évaluer de manière statique la matrice d'image et calculer la valeur de dose dans le cadre de ladite évaluation statique.

**3.** Procédé de fonctionnement selon la revendication 2, **caractérisé par** les étapes qui suivent consistant à :

a) calculer une matrice de comptage à partir de la matrice d'image, dans lequel la matrice de comptage contient, pour les divers éléments d'image de la matrice d'image, respectivement un compteur associé,
b) incrémenter les divers compteurs de la matrice de comptage quand l'élément d'image associé de la matrice d'image est compris entre une valeur limite inférieure et une valeur limite supérieure.

**4.** Procédé de fonctionnement selon la revendication 3, **caractérisé par** l'étape suivante, dans le cadre de l'évaluation statique, consistant à :

a) ajouter les compteurs de la matrice de comptage à une somme, qui reproduit une dose d'énergie du rayonnement ionisant, et/ou
b) calculer une puissance de dose en tant que quotient à partir de la dose d'énergie et d'une durée de mesure.

**5.** Procédé de fonctionnement selon l'une quelconque des revendications précédentes, **caractérisé par** l'étape suivante consistant à :

a) déterminer une matrice erronée avec une pluralité d'éléments de correction, dans lequel les divers éléments de correction de la matrice erronée sont associés respectivement à un élément d'image de la matrice d'image,
b) combiner la matrice d'image à la matrice erronée afin de compenser des erreurs des divers éléments d'image du capteur d'images (6).

**6.** Procédé de fonctionnement selon l'une quelconque des revendications précédentes, **caractérisé par** l'étape suivante consistant à :

a) mémoriser temporairement la matrice d'image mesurée par le capteur d'images (6),
b) calculer une matrice de différence en tant que différence d'une matrice d'image mesurée de manière instantanée avec une matrice d'image mesurée antérieurement et mémorisée temporairement,
c) effectuer l'évaluation statique sur la base de la matrice de différence.

**7.** Procédé de fonctionnement selon l'une quelconque des revendications précédentes, **caractérisé par** l'étape qui suit consistant à :

déterminer une répartition spectrale du rayonnement ionisant par une évaluation de la matrice de comptage.

**8.** Procédé de fonctionnement selon la revendication 7,
**caractérisé par** les étapes qui suivent consistant à :

a) déterminer des groupes d'événements de comptage adjacents dans la matrice de comptage,
b) déterminer l'extension spatiale des groupes,
c) déterminer l'énergie du rayonnement provoqué à partir de l'extension spatiale des groupes.

**9.** Procédé de fonctionnement selon l'une quelconque des revendications précédentes, **caractérisé par** l'étape suivante consistant à :

transmettre la valeur de dose mesurée et/ou un signal de commande qui en est déduit au moyen d'un émetteur se trouvant dans le terminal (1.1 - 1.4) depuis le terminal (1.1 - 1.4) à un dispositif de surveillance (5) externe, en particulier au moyen d'un module Bluetooth, d'un transpondeur RFID, d'un téléphone mobile ou d'un module WIFI.

**10.** Procédé de fonctionnement selon la revendication 9, **caractérisé par** l'étape suivante consistant à :

a) détecter une position géographique du terminal (1.1 - 1.4) au moyen d'un capteur de position intégré dans le terminal (1.1 - 1.4), en particulier au moyen d'un récepteur de navigation par satellites,
b) transmettre la position géographique du terminal (1.1 - 1.4) au dispositif de surveillance (5) externe.

**11.** Procédé de fonctionnement selon l'une quelconque des revendications précédentes, **caractérisé par** l'étape suivante consistant à :

étalonner le calcul de la valeur de dose en ce que le terminal (1.1 - 1.4) est exposé à un projecteur en tant que la normale.

**12.** Procédé de fonctionnement selon l'une quelconque des revendications précédentes, **caractérisé en ce que** le terminal (1.1 - 1.4) est

a) un téléphone mobile, en particulier un téléphone intelligent,
b) un appareil photo numérique, ou
c) un ordinateur transportable, en particulier un notebook, un ordinateur portable, un netbook.

**13.** Procédé de fonctionnement selon l'une quelconque des revendications précédentes, **caractérisé en ce que** le capteur d'images (6) est un capteur CCD ou un capteur CMOS.

**14.** Terminal (1.1 - 1.4), en particulier téléphone mobile, avec

a) un capteur d'images (6) avec une pluralité d'éléments d'image,
b) une mémoire de programme servant à mémoriser un programme d'application, et
c) un processeur servant à exécuter le programme d'application,

**caractérisé en ce**

a) **que** le programme d'application mémorisé dans la mémoire de programme amène, lors de l'exécution par le processeur, le processeur à exécuter le procédé de fonctionnement selon l'une quelconque des revendications précédentes.

15. Système servant à mesurer un rayonnement, avec

a) plusieurs terminaux (1.1 - 1.4) selon la revendication 14, et
b) un dispositif de surveillance (5), ainsi qu'avec
c) une liaison sans fil entre les terminaux et le dispositif de surveillance (5), dans lequel les terminaux (1.1 - 1.4) transmettent la valeur de dose mesurée et/ou la position géographique du terminal (1.1 - 1.4) respectif par l'intermédiaire de la liaison sans fil au dispositif de surveillance.

Fig. 1

EP 2 771 715 B1

Rückführung
gemitteltes Bild

10 — Speicher
Referenzbild

9

6

☐ ☐ ☐ ⋯⋯ ☐
☐ ☐ ☐
☐ ☐
☐

7 — Werteerfassung

8 — Speicher
aktuelles Bild

Differenz

11 — Schwellwert

Figur 2B

Fig. 2A

Fig. 2B

Fig. 3

Fig. 4

**IN DER BESCHREIBUNG AUFGEFÜHRTE DOKUMENTE**

**In der Beschreibung aufgeführte Patentdokumente**

- US 7391028 B1
- DE 102009008025 A1
- US 2009012745 A1
- EP 0757474 A1
- WO 2008110182 A1
- US 4381450 A